# EUROPÄISCHE PATENTSCHRIFT

(11) **EP 4 324 578 B1**
(45) Veröffentlichungstag und Bekanntmachung des Hinweises auf die Patenterteilung: **09.10.2024**
(21) Anmeldenummer: 22190706.6
(22) Anmeldetag: 17.08.2022
(51) Int. Cl.: B22F 1/052, B22F 1/068, B22F 1/107, B22F 7/06, B23K 35/02, B23K 35/30, H01B 1/22, H01L 23/00

(54) **SILBERSINTERPASTE UND DEREN VERWENDUNG ZUM VERBINDEN VON BAUELEMENTEN**
SILVER SINTER PASTE AND ITS USE FOR JOINING COMPONENTS
PÂTE DE FRITTAGE D'ARGENT ET SON UTILISATION POUR RELIER DES COMPOSANTS

(43) Veröffentlichungstag der Anmeldung: 21.02.2024
(73) Patentinhaber: Heraeus Electronics GmbH & Co. KG, 63450 Hanau (DE)
(72) Erfinder: DR. CHEW, Ly May, 63450 Hanau (DE); HERBERT, Frank, 63450 Hanau (DE); SCHMITT, Wolfgang, 63450 Hanau (DE); SCHÄFER, Michael, 63450 Hanau (DE)
(74) Vertreter: Heraeus IP

(56) Entgegenhaltungen:
- WO-A1-2022/128177
- CN-A- 113 084 151
- US-A1- 2021 245 242
- US-A1- 2021 249 376
- US-B2- 11 278 955

## Beschreibung

Die vorliegende Erfindung betrifft eine Silbersinterpaste und ein Verfahren zum Verbinden von Bauelementen, bei dem diese Silbersinterpaste eingesetzt werden kann.

Der hierin verwendete Begriff "Bauelement" bezeichnet insbesondere Bauteile, die in der Elektronik verwendet werden, kurz gesagt, elektronische Bauelemente. Beispiele dafür umfassen Dioden, LEDs (light emitting diodes, lichtemittierende Dioden), Dies, IGBTs (insulated-gate bipolar transistors, Bipolartransistoren mit isolierter Gate-Elektrode), MOSFETs (Metall-Oxid-Halbleiter-Feldeffekttransistoren), ICs (integrated circuits, integrierte Schaltungen), Sensoren, Kühlkörper, Widerstände, Kondensatoren, Spulen, Verbindungselemente (z. B. Clips), Bodenplatten, Antennen, Leadframes, PCBs (printed circuit boards, gedruckte Leiterplatten), flexible Elektronik, Keramiksubstrate, Metallkeramiksubstrate wie beispielsweise DCB-Substrate (direct copper bonded-Substrate), IMS (isoliertes Metallsubstrat) und dergleichen.

Im Bereich der Leistungs- und Konsumerelektronik stellt das Sinterverbinden elektronischer Bauelemente ein gängiges Verfahren dar. Als Verbindungsmaterial wird dabei häufig Metallsinterpaste verwendet, deren Hauptbestandteile dispergierte sinterfähige Metallpartikel sind. Prominente Beispiele für solche Sinterpasten umfassen dem Fachmann bekannte Silbersinterpasten. Die Sinterverbindungstechnik stellt ein sehr einfaches Verfahren zum stabilen Verbinden von Bauelementen dar, wobei die zu verbindenden Bauelemente mit ihren zu verbindenden Kontaktflächen zueinander gewandt in eine Sandwichanordnung überführt werden mit dazwischen appliziertem Sinterverbindungsmaterial, beispielsweise Sinterpaste. Die unter Verwendung von Sinterpaste geschaffene Sandwichanordnung wird anschließend einem Trocknungs- und Sinterschritt unterworfen, in dessen Verlauf die mechanisch feste, elektrisch und wärmeleitfähige Verbindung zwischen den Bauelementen ausgebildet wird. Das mechanisch feste Verbinden zweier Bauelemente ist also ein Befestigen des einen Bauelements an bzw. auf dem zweiten Bauelement über deren jeweilige Kontaktflächen.

Das Dokument WO 2022/128177 A1 offenbart eine Sinterpaste bestehend aus Silberflakes und Silberpartikeln, mit einem Bindemittel aus einem Cellulosederivat. Die Dokumente US 2021/245242 A1 und US 11 278 955 B2 offenbaren weitere Silbersinterpasten aus Mischungen von Silberflakes und Silberpartikeln.

Aufgabe der Erfindung war die Bereitstellung einer insbesondere in Hinblick auf ihr Squeeze-out-Verhalten (Auspressverhalten) verbesserten Metallsinterpaste. Bei dem sogenannten Squeeze-out-Verhalten einer Metallsinterpaste handelt es sich um ein unerwünschtes Phänomen des Austritts von Metallsinterpaste aus dem Randbereich einer sinterzuverbindenden Sandwichanordnung während des Sinterprozesses. Dieses Squeeze-out-Phänomen kann insbesondere beim sogenannten Drucksintern auftreten und es kann im Übrigen noch verstärkt auftreten, wenn sich eine relativ große Menge an Metallsinterpaste zwischen zu verbindenden Bauelementen einer Sandwichanordnung befindet, d.h. wenn die Schichtdicke der Metallsinterpaste hoch ist und/oder wenn die miteinander zu verbindenden Kontaktflächen betreffender Bauelemente groß sind, beispielsweise dergestalt, dass die von den zu verbindenden Kontaktflächen gebildete Überlappungsfläche im Bereich von >100 mm², beispielsweise >100 bis 500 mm² oder mehr, liegt.

Überraschenderweise kann die Aufgabe gelöst werden durch Bereitstellung einer Silbersinterpaste bestehend aus:
(A) 5 bis 40 Gew.-% (Gewichts-%), bevorzugt 10 bis 30 Gew.-%, besonders bevorzugt 15 bis 25 Gew.-% Silberflakes (Silberplättchen) mit einer Teilchengröße D90 im Bereich von 5 bis 20 µm, bevorzugt 7 bis 18 µm, besonders bevorzugt 8 bis 15 µm,
(B) 50 bis 85 Gew.-%, bevorzugt 55 bis 80 Gew.-%, besonders bevorzugt 60 bis 75 Gew.-% Silberpartikeln mit einer Teilchengröße D90 im Bereich von 300 bis 1000 nm, bevorzugt 320 bis 800 nm, besonders bevorzugt 350 bis 500 nm,
(C) 10 bis 25 Gew.-%, bevorzugt 10 bis 20 Gew.-%, besonders bevorzugt 10 bis 15 Gew.-% mindestens eines organischen Lösemittels,
(D) 0 bis 2 Gew.-%, bevorzugt 0,1 bis 1 Gew.-%, besonders bevorzugt 0,1 bis 0,5 Gew.-% mindestens eines Cellulosederivats, und
(E) 0 bis 10 Gew.-% mindestens eines von den Bestandteilen (A) bis (D) verschiedenen Additivs.

In einer bevorzugten Ausführungsform handelt es sich um eine Silbersinterpaste bestehend aus:
(A) 5 bis 40 Gew.-%, bevorzugt 10 bis 30 Gew.-%, besonders bevorzugt 15 bis 25 Gew.-% Silberflakes mit einer Teilchengröße D10 im Bereich von 0,5 bis 2 µm, bevorzugt 0,7 bis 1,5 µm, D50 im Bereich von 2,4 bis 4 µm, bevorzugt 3 bis 3,8 µm und D90 im Bereich von 5 bis 20 µm, bevorzugt 7 bis 18 µm, besonders bevorzugt 8 bis 15 µm,
(B) 50 bis 85 Gew.-%, bevorzugt 55 bis 80 Gew.-%, besonders bevorzugt 60 bis 75 Gew.-% Silberpartikeln mit einer Teilchengröße D10 im Bereich von 90 bis 150 nm, bevorzugt 100 bis 120 nm, D50 im Bereich von 150 bis 250 nm, bevorzugt 200 bis 220 nm, und D90 im Bereich von 300 bis 1000 nm, bevorzugt 320 bis 800 nm, besonders bevorzugt 350 bis 500 nm,
(C) 10 bis 25 Gew.-%, bevorzugt 10 bis 20 Gew.-%, besonders bevorzugt 10 bis 15 Gew.-% mindestens eines organischen Lösemittels,
(D) 0 bis 2 Gew.-%, bevorzugt 0,1 bis 1 Gew.-%, besonders bevorzugt 0,1 bis 0,5 Gew.-% mindestens eines Cellulosederivats, und
(E) 0 bis 10 Gew.-% mindestens eines von den Bestandteilen (A) bis (D) verschiedenen Additivs.

Die hierin im Zusammenhang mit den Silberflakes (A) verwendeten Begriffe "Teilchengröße D10" respektive "Teilchengröße D90" bedeuten den mittels statischer automatisierter Analyse mikroskopischer Bilder bestimmbaren Primärteilchendurchmesser, der von einem Volumenanteil von 10 % der Teilchen respektive von 90 % der Teilchen unterschritten wird. Der hierin im Zusammenhang mit den Silberflakes (A) verwendete Begriff "Teilchengröße D50" bedeutet den mittels statischer automatisierter Analyse mikroskopischer Bilder bestimmbaren volumenmittleren Primärteilchendurchmesser. Als Maß für den Primärteilchendurchmesser kann zweckmäßig der sogenannte Equivalent Circular Area Diameter (ECAD) verwendet werden (vgl. RENLIANG XU ET AL: "Comparison of sizing small particles using different technologies", POWDER TECHNOLOGY, ELSEVIER, BASEL (CH), Bd. 132, Nr. 2-3, 24. Juni 2003 (2003-06-24), Seiten 145-153). Die statische automatisierte Analyse der mikroskopischen Bilder kann beispielsweise mit dem Messsystem Morphologi 4 von Malvern Instruments nach der Trockenbestimmungsmethode durchgeführt werden.

Die hierin im Zusammenhang mit den Silberpartikeln (B) verwendeten Begriffe "Teilchengröße D10" respektive "Teilchengröße D90" bedeuten den mittels Laserbeugung bestimmbaren Primärteilchendurchmesser, der von einem Volumenanteil von 10 % der Teilchen respektive von 90 % der Teilchen unterschritten wird. Der hierin im Zusammenhang mit den Silberpartikeln (B) verwendete Begriff "Teilchengröße D50" bedeutet den mittels Laserbeugung bestimmbaren volumenmittleren Primärteilchendurchmesser. Als Maß für den Primärteilchendurchmesser kann dabei zweckmäßig der sogenannte Equivalent Circular Area Diameter (ECAD) verwendet werden (vgl. RENLIANG XU ET AL: "Comparison of sizing small particles using different technologies", POWDER TECHNOLOGY, ELSEVIER, BASEL (CH), Bd. 132, Nr. 2-3, 24. Juni 2003 (2003-06-24), Seiten 145-153). Laserbeugungsmessungen können mit einem entsprechenden Teilchengrößenmessgerät, beispielsweise einem Mastersizer 3000 oder einem Mastersizer 2000 von Malvern Instruments nach der Nassbestimmungsmethode durchgeführt werden. Bei der Nassbestimmungsmethode können im Rahmen der Probenvorbereitung beispielsweise 1 g Silberpartikel vom Typ (B) in 200 ml Ethanol mittels Ultraschall dispergiert werden.

Bei Bestandteil (A) handelt es sich um Silberflakes mit einer Teilchengröße D90 im Bereich von 5 bis 20 µm, bevorzugt 7 bis 18 µm, besonders bevorzugt 8 bis 15 µm. Bevorzugt haben die Silberflakes eine Teilchengröße D10 im Bereich von 0,5 bis 2 µm, bevorzugt 0,7 bis 1,5 µm, D50 im Bereich von 2,4 bis 4 µm, bevorzugt 3 bis 3,8 µm, und D90 im Bereich von 5 bis 20 µm, bevorzugt 7 bis 18 µm, besonders bevorzugt 8 bis 15 µm.

Das Aspektverhältnis der Silberflakes kann beispielsweise bei > 5 : 1 liegen, beispielsweise bei > 5 : 1 bis mehrere Hundert: 1. Das Aspektverhältnis von Teilchen beschreibt den Quotienten aus größter und kleinster Längenausdehnung derselben und damit deren Form; nur um Missverständnissen vorzubeugen, im Falle von Teilchen in Form von Flakes oder Plättchen ist der Quotient aus größter und kleinster Längenausdehnung der Quotient aus größter Längenausdehnung und der Plättchendicke. Es kann durch Rasterelektronenmikroskopie und Auswertung der elektronenmikroskopischen Bilder durch Bestimmung der Abmessungen einer statistisch bedeutsamen Anzahl von einzelnen Teilchen bestimmt werden.

Die Silberflakes können eine spezifische Oberfläche beispielsweise im Bereich von 1 bis 5 m²/g aufweisen. Die spezifische Oberfläche in m²/g kann mittels BET-Messung gemäß DIN ISO 9277:2014-01 (statisch-volumetrisches Messverfahren, verwendetes Gas: Stickstoff) bestimmt werden.

Die Silberflakes können eine Stampfdichte beispielsweise im Bereich von 1 bis 5 g/cm³ aufweisen. Bei der Stampfdichte handelt es sich um die durch Stampfen oder Rütteln gegenüber der Schüttdichte eines Feststoffs weiter verdichtete Dichte. Die Stampfdichte in g/cm³ kann gemäß DIN EN ISO 787-11:1995-10 bestimmt werden.

Die Silberflakes sind üblicherweise gecoatet (beschichtet). Die hier gemachten Gewichtsangaben schließen das Gewicht des Coatings (Beschichtung) auf den Silberflakes mit ein.

Die Silberflakes können Flakes aus reinem Silber (Reinheit des Silbers von wenigstens 99,9 Gew.-%) und/oder solche aus Silberlegierungen mit bis zu 10 Gew.-% wenigstens eines anderen Legierungsmetalls umfassen. Beispiele für geeignete Legierungsmetalle sind Kupfer, Gold, Nickel, Palladium, Platin und Aluminium. Bevorzugt sind Silberflakes aus reinem Silber.

Das vorerwähnte Coating kann eine festhaftende Schicht auf der Oberfläche der Silberflakes sein. Üblicherweise handelt es sich um ein organisches Coating. Der Anteil des organischen Coatings kann beispielsweise im Bereich von 0,5 bis 1,5 Gew.-%, bezogen auf Silber respektive Silberlegierung, liegen. Im Allgemeinen kann ein solches organisches Coating 90 bis 100 Gew.-% einer oder mehrerer Fettsäuren und/oder Fettsäurederivate umfassen. Beispiele für Fettsäurederivate umfassen insbesondere Fettsäuresalze und Fettsäureester. Beispiele für Fettsäuren umfassen Caprylsäure (Octansäure), Caprinsäure (Decansäure), Laurinsäure (Dodecansäure), Myristinsäure (Tetradecansäure), Palmitinsäure (Hexadecansäure), Margarinsäure (Heptadecansäure), Stearinsäure (Octadecansäure), Ölsäure (9-Octadecensäure), Arachinsäure (Eicosansäure/Icosansäure), Behensäure (Docosansäure), Lignocerinsäure (Tetracosansäure).

Bei einer im Temperaturbereich beispielsweise von 25°C bis 400°C mit einer Aufheizrate von 10K/min unter Luftzutritt durchgeführten DSC-Analyse (differential scanning calorimetry, dynamische Differenzkalorimetrie) der gecoateten Silberflakes kann sich das Coating der Silberflakes beispielsweise durch einen oder zwei exotherme Peaks im Temperaturbereich beispielsweise von 200 bis 270°C auszeichnen.

Bei einer im Temperaturbereich beispielsweise von 25°C bis 400°C mit einer Aufheizrate von 10K/min unter Luftzutritt durchgeführten TGA-Analyse (thermogravimetrische Analyse) der gecoateten Silberflakes kann sich das Coating der Silberflakes beispielsweise durch einen beispielsweise bei 130 bis 150 °C beginnenden und beispielsweise bei 220 bis 240°C endenden Gewichtsverlust beispielsweise im Bereich von 0,7 bis 1,5 Gew.-% auszeichnen.

Silberflakes vom Typ (A) sind beispielsweise bei den Firmen Metalor oder Ames Goldsmith erhältlich.

Bei Bestandteil (B) handelt es sich um Silberpartikel mit einer Teilchengröße D90 im Bereich von 300 bis 1000 nm, bevorzugt 320 bis 800 nm, besonders bevorzugt 350 bis 500 nm. Bevorzugt haben die Silberpartikel eine Teilchengröße D10 im Bereich von 90 bis 150 nm, bevorzugt 100 bis 120 nm, D50 im Bereich von 150 bis 250 nm, bevorzugt 200 bis 220 nm, und D90 im Bereich von 300 bis 1000 nm, bevorzugt 320 bis 800 nm, besonders bevorzugt 350 bis 500 nm. Bei den Silberpartikeln des Bestandteils (B) handelt es sich um sogenannte Submikron-Silberpartikel, nicht zu verwechseln mit noch kleineren Nano-Silberpartikeln, welche D90-Teilchengrößen von <250 nm aufweisen.

Die Silberpartikel sind keine Silberflakes, ihr Aspektverhältnis ist deutlich kleiner als das von Silberflakes, es liegt beispielsweise im Bereich von 1 : 1 bis 5 : 1. Ideal kugelförmige Partikel haben ein Aspektverhältnis von 1 : 1. Das Aspektverhältnis der Silberpartikel im Bereich von 1 : 1 bis 5 : 1 bedeutet, dass die Silberpartikel beispielsweise eine sphärische, eine im Wesentlichen sphärische, eine elliptische, eine eiförmige oder eine unregelmäßige Form aufweisen, keinesfalls jedoch die Form von Flakes.

Die Silberpartikel können Partikel aus reinem Silber (Reinheit des Silbers von wenigstens 99,9 Gew.-%) und/oder solche aus Silberlegierungen mit bis zu 10 Gew.-% wenigstens eines anderen Legierungsmetalls umfassen. Beispiele für geeignete Legierungsmetalle sind Kupfer, Gold, Nickel, Palladium, Platin und Aluminium. Bevorzugt sind Silberpartikel aus reinem Silber.

Die Silberpartikel können eine spezifische Oberfläche beispielsweise im Bereich von 1 bis 8 m²/g aufweisen. Die spezifische Oberfläche in m²/g kann mittels BET-Messung gemäß DIN ISO 9277:2014-01 (statisch-volumetrisches Messverfahren, verwendetes Gas: Stickstoff) bestimmt werden.

Die Silberpartikel können eine Stampfdichte beispielsweise im Bereich von 3 bis 6 g/cm³ aufweisen. Bei der Stampfdichte handelt es sich um die durch Stampfen oder Rütteln gegenüber der Schüttdichte eines Feststoffs weiter verdichtete Dichte. Die Stampfdichte in g/cm³ kann gemäß DIN EN ISO 787-11:1995-10 bestimmt werden.

Die Silberpartikel sind üblicherweise gecoatet. Die hier gemachten Gewichtsangaben schließen dann das Gewicht des Coatings auf den Silberpartikeln mit ein.

Das vorerwähnte Coating kann eine festhaftende Schicht auf der Oberfläche der Silberpartikel sein. Üblicherweise handelt es sich um ein organisches Coating. Der Anteil des organischen Coatings kann beispielsweise im Bereich von 0,5 bis 1,5 Gew.-%, bezogen auf Silber respektive Silberlegierung, liegen. Im Allgemeinen kann ein solches organisches Coating 90 bis 100 Gew.-% einer oder mehrerer Fettsäuren und/oder Fettsäurederivate umfassen. Beispiele für Fettsäurederivate umfassen insbesondere Fettsäuresalze und Fettsäureester. Beispiele für Fettsäuren umfassen Caprylsäure (Octansäure), Caprinsäure (Decansäure), Laurinsäure (Dodecansäure), Myristinsäure (Tetradecansäure), Palmitinsäure (Hexadecansäure), Margarinsäure (Heptadecansäure), Stearinsäure (Octadecansäure), Ölsäure (9-Octadecensäure), Arachinsäure (Eicosansäure/Icosansäure), Behensäure (Docosansäure), Lignocerinsäure (Tetracosansäure).

Bei einer im Temperaturbereich beispielsweise von 25°C bis 400°C mit einer Aufheizrate von 10K/min unter Luftzutritt durchgeführten DSC-Analyse der gecoateten Silberpartikel kann sich das Coating der Silberpartikel beispielsweise durch einen oder zwei exotherme Peaks im Temperaturbereich beispielsweise von 200 bis 270°C auszeichnen.

Bei einer im Temperaturbereich beispielsweise von 25°C bis 400°C mit einer Aufheizrate von 10K/min unter Luftzutritt durchgeführten TGA-Analyse der gecoateten Silberpartikel kann sich das Coating der Silberpartikel beispielsweise durch einen beispielsweise bei 140 bis 160 °C beginnenden und beispielsweise bei 230 bis 250°C endenden Gewichtsverlust beispielsweise im Bereich von 0,9 bis 1,4 Gew.-% auszeichnen.

Silberpartikel vom Typ (B) sind beispielsweise bei der Firma Ames Goldsmith erhältlich.

Bei Bestandteil (C) handelt es sich um mindestens ein organisches Lösemittel. Beispiele für geeignete organische Lösemittel umfassen Terpineole, N-Methyl-2-pyrrolidon, Ethylenglykol, Dimethylacetamid, 1-Tridecanol, 2-Tridecanol, 3-Tridecanol, 4-Tridecanol, 5-Tridecanol, 6-Tridecanol, Isotridecanol, 2-Ethyl-1,3-hexandiol, 2-(2-Ethylhexyloxy)-ethanol, Benzylalkohol, Diethylenglykolmonobutylether, Dipropylenglykolmonopropylether, Dipropylenglykolmonobutylether, dibasische Ester (vorzugsweise Dimethylester der Glutar-, Adipin- oder Bernsteinsäure oder Mischungen davon), Glycerin, Diethylenglykol, Triethylenglykol und aliphatische, insbesondere gesättigte aliphatische Kohlenwasserstoffe mit 5 bis 32 C-Atomen, mehr bevorzugt 10 bis 25 C-Atomen und noch mehr bevorzugt 16 bis 20 C-Atomen.

Beim optionalen, bevorzugt jedoch von der erfindungsgemäßen Silbersinterpaste umfassten Bestandteil (D) handelt es sich um mindestens ein Cellulosederivat. Beispiele umfassen Methylcellulose, Ethylcellulose, Ethylmethylcellulose, Carboxycellulose, Hydroxypropylcellulose, Hydroxyethylcellulose und Hydroxymethylcellulose.

Beim optionalen Bestandteil (E) handelt es sich um mindestens ein von den Bestandteilen (A) bis (D) verschiedenes Additiv. Beispiele umfassen Tenside, Entschäumer, Benetzungsmittel und Antikorrosionsadditive.

Bestandteil (E) umfasst bevorzugt keine Glaspartikel (Glasfritte); anders ausgedrückt, die erfindungsgemäße Silbersinterpaste umfasst bevorzugt keine Glaspartikel.

Bestandteil (E) umfasst insbesondere bevorzugt keine thermisch zersetzbaren Metallprecursoren (Metallvorläuferverbindungen), also keine während des Sintervorgangs zum entsprechenden Metall zersetzbare Metallprecursoren. In Silbersinterpasten des Standes der Technik mitunter übliche entsprechende Silberprecursoren wie beispielsweise Silberoxid, Silbercarbonat, Silberlaktat und dergleichen sind also insbesondere bevorzugt nicht von Bestandteil (E) umfasst. Anders ausgedrückt, die erfindungsgemäße Silbersinterpaste umfasst insbesondere bevorzugt keine thermisch zersetzbaren Metallprecursoren. Es hat sich im Übrigen gezeigt, dass sich die Nichtanwesenheit solcher Metall- oder Silberprecursoren positiv auf die Lagerstabilität einer erfindungsgemäßen Silbersinterpaste auswirkt.

Erfindungswesentliches Kennzeichen der erfindungsgemäßen Silbersinterpaste scheint zu sein, dass sie eine Kombination aus einem relativ kleinen Anteil von Silberflakes vom Typ (A) mit einem relativ großen Anteil von Submikron-Silberpartikeln vom Typ (B) aufweist, und dabei insbesondere bevorzugt ohne Anteile besagter Metall- bzw. Silberprecursoren.

Die Summe der Gew.-% der Bestandteile (A) bis (E) beträgt 100 Gew.-%, bezogen auf die erfindungsgemäße Silbersinterpaste. Dementsprechend kann die Herstellung einer erfindungsgemäßen Silbersinterpaste durch Vermischen der Bestandteile (A) bis (C) respektive (A) bis (D) respektive (A) bis (E) erfolgen. Dabei können übliche dem Fachmann bekannte Vorrichtungen verwendet werden, beispielsweise Rührwerke, Dreiwalzwerke, Leitstrahlmischer und/oder Dispermixer.

Die erfindungsgemäße Silbersinterpaste kann in einem Sinterverfahren, beispielsweise in einem Sinterverfahren wie vorstehend erläutert, eingesetzt werden. Unter Sintern wird das Verbinden von zwei oder mehr Bauelementen durch Erhitzen unter Vermeidung dessen, dass die Silberflakes und die Silberpartikel die flüssige Phase erreichen, verstanden. Die dabei gebildete feste mechanische Verbindung ist zugleich elektrisch und thermisch leitfähig; sie besteht praktisch oder nahezu vollständig aus Silber. Die Erfindung betrifft insofern auch ein Verfahren zum Verbinden von Bauelementen, bei dem man (1) eine Sandwichanordnung bereitstellt, die wenigstens zwei Bauelemente und eine zwischen den Bauelementen befindliche erfindungsgemäße Silbersinterpaste aufweist, (2) optional, jedoch bevorzugt die Silbersinterpaste trocknet und (3) die Sandwichanordnung sintert. Unter Trocknen wird das Entfernen von organischem Lösemittel aus der applizierten erfindungsgemäßen Sinterpaste verstanden. Beim Arbeiten mit einer erfindungsgemäßen Silbersinterpaste bilden die Schritte (1), (2) und (3) eine Schrittfolge vom Typ (1)-(2)-(3) mit Schritt (2) als optionalem Schritt. In einer Ausführungsform des mit erfindungsgemäßer Silbersinterpaste durchgeführten Verfahrens kann Schritt (1) schon ein Trocknen umfassen und Schritt (2) kann somit entfallen; in einer anderen Ausführungsform umfasst Schritt (1) das Trocknen nicht oder nur teilweise und der optionale Schritt (2) kann entfallen oder bevorzugt stattfinden; falls Schritt (2) hier entfällt, kann er im Zuge von Schritt (3) stattfinden bzw. damit überlappen.

Die Bauelemente können - soweit sie nicht ohnehin aus Metall bestehen - wenigstens eine Metallkontaktfläche, beispielsweise in Form einer Metallisierungsschicht, umfassen, worüber die schon erwähnte Sandwichanordnung im Rahmen des erfindungsgemäßen Verfahrens erfolgt.

In Schritt (1) werden zunächst die zwei oder mehr Bauelemente miteinander in Kontakt gebracht. Das Kontaktieren erfolgt dabei über die erfindungsgemäße und optional bereits getrocknete Silbersinterpaste. Zu diesem Zweck wird eine Sandwichanordnung bereitgestellt, bei der sich zwischen jeweils zwei der wenigstens zwei Bauelemente erfindungsgemäße Silbersinterpaste befindet. Unter Sandwichanordnung ist eine Anordnung zu verstehen, bei der sich zwei Bauelemente übereinander befinden und die Bauelemente im Wesentlichen parallel zueinander angeordnet sind.

Die Sandwichanordnung kann nach einem aus dem Stand der Technik bekannten Verfahren hergestellt werden. Dabei wird die betreffende Metallkontaktfläche eines der Bauelemente mit der erfindungsgemäßen Silbersinterpaste versehen. Anschließend wird das andere Bauelement mit seiner Metallkontaktfläche auf die Silbersinterpaste, die auf die Metallkontaktfläche des einen Bauelements aufgebracht worden ist, aufgesetzt.

Die Auftragung der erfindungsgemäßen Silbersinterpaste auf die betreffende Metallkontaktfläche des einen Bauelements kann mittels herkömmlicher Verfahren erfolgen, beispielsweise mittels Druckverfahren wie Siebdruck oder Schablonendruck. Andererseits kann die Auftragung erfindungsgemäßer Silbersinterpaste auch mittels Dispenstechnik, Jetten, mittels Pintransfer oder durch Dippen erfolgen.

Die Nassschichtdicke erfindungsgemäßer Silbersinterpaste liegt vorzugsweise im Bereich von 20 bis 400 µm. Die bevorzugte Nassschichtdicke ist beispielsweise abhängig vom gewählten Auftragungsverfahren. Wird die erfindungsgemäße Silbersinterpaste beispielsweise mittels Siebdruckverfahren aufgetragen, dann kann eine Nassschichtdicke von beispielsweise 20 bis 60 µm bevorzugt sein. Erfolgt die Auftragung beispielsweise mittels Schablonendruck, dann kann die bevorzugte Nassschichtdicke beispielsweise im Bereich von 20 bis 400 µm liegen. Beispielsweise bei der Dispenstechnik kann die bevorzugte Nassschichtdicke beispielsweise im Bereich von 20 bis 400 µm liegen je nach verwendetem Auftragungswerkzeug, beispielsweise bei Verwendung einer Hohlnadel im Bereich von 20 bis 100 µm oder beispielsweise bei Verwendung einer zugleich als Rakel fungierenden Breitschlitzdüse im Bereich von 50 bis 400 µm.

Im Anschluss an die Auftragung der erfindungsgemäßen Silbersinterpaste auf die Metallkontaktfläche des einen Bauelements wird die mit der gegebenenfalls schon teilweise oder vollständig getrockneten Silbersinterpaste versehene Metallkontaktfläche dieses Bauelements mit der entsprechenden Metallkontaktfläche des damit zu verbindenden Bauelements über die Silbersinterpaste in Kontakt gebracht. Somit befindet sich zwischen den zu verbindenden Bauelementen eine Schicht nicht, teilweise oder vollständig getrocknete erfindungsgemäße Silbersinterpaste im Sinne der Bildung der Sandwichanordnung.

Gemäß einer bevorzugten Ausführungsform liegt der Anteil an organischem Lösemittel in der Silbersinterpaste nach der Trocknung beispielsweise bei 0 bis 5 Gew.-%, bezogen auf den ursprünglichen Anteil an organischem Lösemittel in der erfindungsgemäßen Silbersinterpaste. Mit anderen Worten, bei der Trocknung gemäß dieser bevorzugten Ausführungsform werden beispielsweise 95 bis 100 Gew.-% des oder der ursprünglich in der erfindungsgemäßen Silbersinterpaste enthaltenen organischen Lösemittel entfernt.

Die Trocknungstemperatur in einem stattfindenden Schritt (2) liegt vorzugsweise im Bereich von 100 bis 150 °C. Übliche Trocknungszeiten liegen beispielsweise im Bereich von 5 bis 45 Minuten. Zur Verkürzung der Trocknungszeit kann unterstützend ein Vakuum verwendet werden, beispielsweise ein Druck im Bereich von 100 bis 300 mbar.

Nach Beendigung von Schritt (1) respektive Schritt (2) wird die Sandwichanordnung schließlich einem Sinterprozess unterworfen. Dieser Sinterschritt (3) des erfindungsgemäßen Verfahrens kann unter Druckanwendung oder drucklos durchgeführt werden. Drucklose Durchführung bedeutet, dass trotz Verzichts auf die Anwendung von mechanischem Druck eine hinreichend feste Verbindung zwischen den Bauelementen erzielt werden kann. Wie schon eingangs gesagt zeichnet sich die erfindungsgemäße Silbersinterpaste durch ein gering ausgeprägtes oder bevorzugt sogar fehlendes Squeeze-out-Verhalten aus; mit anderen Worten, die erfindungsgemäße Silbersinterpaste weist eine besondere Eignung für das als Drucksintern ausgestaltete erfindungsgemäße Verfahren auf.

Das eigentliche Sintern erfolgt bei einer Temperatur von beispielsweise 200 bis 280 °C und dabei wie gesagt entweder als druckloser Prozess oder zweckmäßig Gebrauch machend vom gering ausgeprägten oder nicht vorhandenen Squeeze-out-Verhalten als Drucksintern.

Beim Drucksintern liegt der Prozessdruck vorzugsweise unter 30 MPa und mehr bevorzugt unter 15 MPa. Beispielsweise liegt der Prozessdruck im Bereich von 1 bis 30 MPa und mehr bevorzugt im Bereich von 5 bis 15 MPa.

Die Sinterzeit liegt beispielsweise im Bereich von 2 bis 90 Minuten, beim Drucksintern beispielsweise im Bereich von 2 bis 5 Minuten, beim Drucklossintern beispielsweise im Bereich von 30 bis 75 Minuten.

Der Sinterprozess kann in einer Atmosphäre erfolgen, die keinen besonderen Beschränkungen unterliegt. So kann das Sintern einerseits in einer Atmosphäre durchgeführt werden, die Sauerstoff enthält. Andererseits ist es auch möglich, das Sintern in sauerstofffreier Atmosphäre oder im Vakuum durchzuführen. Unter sauerstofffreier Atmosphäre ist im Rahmen der Erfindung eine Atmosphäre zu verstehen, deren Sauerstoffgehalt nicht mehr als 300 Gew.-ppm (Gewichts-ppm), vorzugsweise nicht mehr als 100 Gew.-ppm und noch mehr bevorzugt nicht mehr als 50 Gew.-ppm beträgt.

Das Sintern wird in einer herkömmlichen, zum Sintern geeigneten Vorrichtung durchgeführt, in der sich die vorstehend beschriebenen Prozessparameter einstellen lassen.

### Beispiele

### 1. Herstellung von Silbersinterpasten:

Die erfindungsgemäßen Silbersinterpasten 1 bis 5 sowie die Vergleichspasten V1-V3 wurden gemäß Tabelle 1 hergestellt (alle Angaben in Gew.-%). Hierzu wurden zunächst die organischen Lösemittel sowie ggf. die Ethylcellulose bei 80°C zu einem Lösemittelsystem homogenisiert. Anschließend wurden portionsweise die Silberflakes und die Silberpartikel dem Lösemittelsystem zugegeben und vollständig dispergiert.

### 2. Evaluierung der Silbersinterpasten:

### a) Herstellung von als Modell dienenden Testaufbauten:

Die erfindungsgemäßen Silbersinterpasten 1 bis 5 sowie die Vergleichspasten V1 bis V3 wurden mittels Schablonendruck auf je einem Silber-metallisierten Kupfer-Keramik-Substrat mit einer Nassschichtdicke von 300 µm appliziert. Direkt im Anschluss wurden die jeweiligen Bereiche der aufgedruckten Silbersinterpaste mit je einem weiteren Silber-metallisierten Kupfer-Keramik-Substrat (20 mm x 20 mm) vollflächig bestückt. Die so geschaffenen Sandwichanordnungen wurden an normaler Luftatmosphäre für 10 Minuten bei 120°C getrocknet. Das anschließende Drucksintern erfolgte unter Stickstoffatmosphäre (<100 ppm Sauerstoff) in einer Heißpresse bei 230 °C und 12 MPa für 5 Minuten.

### b) Bewertung des Squeeze-out-Verhaltens:

Die gesinterten Testaufbauten wurden visuell bewertet, inwiefern ein unerwünschtes randseitiges Herauspressen von Silbersinterpaste erfolgt war.

War keine beim Sintervorgang randseitig unter der Kontaktfläche des bestückten Substrats herausgepresste und gesinterte Sinterpaste sichtbar, wurde das Auspressverhalten mit "+" (kein unerwünschtes squeeze out) bewertet.

War gesinterte Silbersinterpaste an mindestens einer Randseite des Testaufbaus neben dem bestückten Silber-metallisierten Kupfer-Keramik-Substrat an nur <20% der umlaufenden Kante sichtbar, wurde das Auspressverhalten als "gering" eingestuft.

War gesinterte Silbersinterpaste an mindestens einer Randseite des Testaufbaus neben dem bestückten Silber-metallisierten Kupfer-Keramik-Substrat an >50% der umlaufenden Kante sichtbar, wurde das Auspressverhalten als "stark" eingestuft.

### c) Bestimmung der Scherfestigkeit:

Für die Bestimmung der Scherfestigkeit wurden die Bauelemente mit einem Schermeißel bei einer Geschwindigkeit von 2 mm/min bei 20°C abgeschert. Die Kraft wurde mittels einer Kraftmessdose von 10 kN aufgenommen (Gerät von Zwick Roell Z010, Deutschland).

**Tabelle 1: Zusammensetzung sowie Bewertung erfindungsgemäßer Silbersinterpasten 1 bis 5 sowie der Vergleichspasten V1 bis V3**

| | **1** | **2** | **3** | **4** | **5** | **V1** | **V2** | **V3** |
|---|---|---|---|---|---|---|---|---|
| Silberflakes* | 7 | 10 | 12 | 17 | 30 | 52 | 84 | - |
| Silberpartikel** | 80 | 77 | 75 | 70 | 57 | 35 | - | 87 |
| Ethylcellulose | 0,1 | - | 0,1 | 0,1 | 0,1 | 0,1 | 0,3 | 0,1 |
| Terpineol | 6,45 | 6,50 | 6,45 | 6,45 | 6,45 | 6,45 | 7,85 | 6,45 |
| Diethylenglycolbutylether | 6,45 | 6,50 | 6,45 | 6,45 | 6,45 | 6,45 | - | 6,45 |
| Dimethylsuccinat | - | - | - | - | - | - | 7,85 | - |

| | Bewertung: | | | | | | | |
|---|---|---|---|---|---|---|---|---|
| Squeeze-out-Verhalten | gering | + | + | + | + | + | + | stark |
| Scherfestigkeit (N/mm²) | 40 | 40 | 41 | 45 | 40 | 30 | 30 | 55 |

| | | | | | | | | |
|---|---|---|---|---|---|---|---|---|
| * Mit Fettsäure gecoatete Silberflakes: D90: 9 µm, D50: 3 µm, D10: 1 µm ** Mit Fettsäure gecoatete Silberpartikel: D90: 400 nm, D50: 200 nm, D10: 105 nm | | | | | | | | |

## Patentansprüche

1. Silbersinterpaste bestehend aus:
(A) 5 bis 40 Gew.-% Silberflakes mit einer Teilchengröße D90 im Bereich von 5 bis 20 µm,
(B) 50 bis 85 Gew.-% Silberpartikeln mit einer Teilchengröße D90 im Bereich von 300 bis 1000 nm,
(C) 10 bis 25 Gew.-% mindestens eines organischen Lösemittels,
(D) 0 bis 2 Gew.-% mindestens eines Cellulosederivats, und
(E) 0 bis 10 Gew.-% mindestens eines von den zuvor erwähnten Bestandteilen (A) bis (D) verschiedenen Additivs,
wobei der im Zusammenhang mit den Silberflakes (A) verwendete Begriff "Teilchengröße D90" den mittels statischer automatisierter Analyse mikroskopischer Bilder bestimmten Primärteilchendurchmesser, der von einem Volumenanteil von 90 % der Teilchen unterschritten wird, bedeutet, und
wobei der im Zusammenhang mit den Silberpartikeln (B) verwendete Begriff "Teilchengröße D90" den mittels Laserbeugung bestimmten Primärteilchendurchmesser, der von einem Volumenanteil von 90 % der Teilchen unterschritten wird, bedeutet.

2. Silbersinterpaste nach Anspruch 1 mit einer Teilchengröße D10 im Bereich von 0,5 bis 2 µm und D50 im Bereich von 2,4 bis 4 µm der Silberflakes und mit einer Teilchengröße D10 im Bereich von 90 bis 150 nm und D50 im Bereich von 150 bis 250 nm der Silberpartikel,
wobei der im Zusammenhang mit den Silberflakes (A) verwendete Begriff "Teilchengröße D10" den mittels statischer automatisierter Analyse mikroskopischer Bilder bestimmten Primärteilchendurchmesser, der von einem Volumenanteil von 10 % der Teilchen unterschritten wird, bedeutet,
wobei der im Zusammenhang mit den Silberflakes (A) verwendete Begriff "Teilchengröße D50" den mittels statischer automatisierter Analyse mikroskopischer Bilder bestimmten volumenmittleren Primärteilchendurchmesser bedeutet,
wobei der im Zusammenhang mit den Silberpartikeln (B) verwendete Begriff "Teilchengröße D10" den mittels Laserbeugung bestimmten Primärteilchendurchmesser, der von einem Volumenanteil von 10 % der Teilchen unterschritten wird, bedeutet, und
wobei der im Zusammenhang mit den Silberpartikeln (B) verwendete Begriff "Teilchengröße D50" den mittels Laserbeugung bestimmten volumenmittleren Primärteilchendurchmesser bedeutet.

3. Silbersinterpaste nach Anspruch 1 oder 2 mit einem durch Rasterelektronenmikroskopie und Auswertung der elektronenmikroskopischen Bilder durch Bestimmung der Abmessungen einer statistisch bedeutsamen Anzahl von einzelnen Teilchen bestimmten Aspektverhältnis der Silberflakes von > 5 : 1.

4. Silbersinterpaste nach einem der vorhergehenden Ansprüche mit einer mittels BET-Messung gemäß DIN ISO 9277:2014-01, statisch-volumetrisches Messverfahren, verwendetes Gas: Stickstoff, bestimmten spezifischen Oberfläche der Silberflakes im Bereich von 1 bis 5 m²/g.

5. Silbersinterpaste nach einem der vorhergehenden Ansprüche mit einer gemäß DIN EN ISO 787-11:1995-10 bestimmten Stampfdichte der Silberflakes im Bereich von 1 bis 5 g/cm³.

6. Silbersinterpaste nach einem der vorhergehenden Ansprüche mit einem durch Rasterelektronenmikroskopie und Auswertung der elektronenmikroskopischen Bilder durch Bestimmung der Abmessungen einer statistisch bedeutsamen Anzahl von einzelnen Teilchen bestimmten Aspektverhältnis der Silberpartikel im Bereich von 1 : 1 bis 5 : 1.

7. Silbersinterpaste nach einem der vorhergehenden Ansprüche mit einer mittels BET-Messung gemäß DIN ISO 9277:2014-01, statisch-volumetrisches Messverfahren, verwendetes Gas: Stickstoff, bestimmten spezifischen Oberfläche der Silberpartikel im Bereich von 1 bis 8 m²/g.

8. Silbersinterpaste nach einem der vorhergehenden Ansprüche mit einer gemäß DIN EN ISO 787-11:1995-10 bestimmten Stampfdichte der Silberpartikel im Bereich von 3 bis 6 g/cm³.

9. Silbersinterpaste nach einem der vorhergehenden Ansprüche, wobei das mindestens ein Cellulosederivat ausgewählt ist aus der Gruppe bestehend aus Methylcellulose, Ethylcellulose, Ethylmethylcellulose, Carboxycellulose, Hydroxypropylcellulose, Hydroxyethylcellulose und Hydroxymethylcellulose.

10. Silbersinterpaste nach einem der vorhergehenden Ansprüche umfassend keine Glaspartikel.

11. Silbersinterpaste nach einem der vorhergehenden Ansprüche umfassend keine thermisch zersetzbaren Metallprecursoren.

12. Verfahren zum Verbinden von Bauelementen, bei dem man (1) eine Sandwichanordnung bereitstellt, die wenigstens zwei Bauelemente und eine zwischen den Bauelementen befindliche Silbersinterpaste gemäß einem der vorhergehenden Ansprüche aufweist, (2) optional die Silbersinterpaste trocknet und (3) die Sandwichanordnung sintert.

13. Verfahren nach Anspruch 12, wobei man unter Druckanwendung oder drucklos sintert.

14. Verfahren nach Anspruch 12 oder 13, wobei es sich bei den Bauelementen um in der Elektronik verwendete Bauteile handelt.

## Claims

1. A silver sinter paste consisting of:
(A) 5 to 40 wt.% of silver flakes having a particle size D90 in the range of 5 to 20 µm,
(B) 50 to 85 wt.% of silver particles having a particle size D90 in the range of 300 to 1000 nm,
(C) 10 to 25 wt.% of at least one organic solvent,
(D) 0 to 2 wt.% of at least one cellulose derivative, and
(E) 0 to 10 wt.% of at least one additive other than the previously mentioned constituents (A) to (D),
wherein the term "particle size D90" used in connection with the silver flakes (A) means the primary particle diameter, determined by means of automated static analysis of microscopic images, with which a volume proportion of 90% of the particles is below said primary particle diameter, and
wherein the term "particle size D90" used in connection with the silver particles (B) means the primary particle diameter, determined by means of laser diffraction, with which a volume proportion of 90% of the particles is below said primary particle diameter.

2. The silver sinter paste according to claim 1, in which the silver flakes have a particle size D10 in the range of 0.5 to 2 µm and a particle size D50 in the range of 2.4 to 4 µm, and in which the silver particles have a particle size D10 in the range of 90 to 150 nm and a particle size D50 in the range of 150 to 250 nm, wherein the term "particle size D10" used in connection with the silver flakes (A) means the primary particle diameter, determined by means of automated static analysis of microscopic images, with which a volume proportion of 10% of the particles is below said primary particle diameter,
wherein the term "particle size D50" used in connection with the silver flakes (A) means the volume-average primary particle diameter, determined by means of automated static analysis of microscopic images,
wherein the term "particle size D10" used in connection with the silver particles (B) means the primary particle diameter, determined by means of laser diffraction, with which a volume proportion of 10% of the particles is below said primary particle diameter, and
wherein the term "particle size D50" used in connection with the silver particles (B) means the volume-average primary particle diameter, determined by means of laser diffraction.

3. The silver sinter paste according to claim 1 or 2, in which the silver flakes have an aspect ratio of > 5:1, determined by scanning electron microscopy and evaluation of the electron microscopic images by determining the dimensions of a statistically significant number of individual particles.

4. The silver sinter paste according to any of the preceding claims, in which the silver flakes have a specific surface area in the range of 1 to 5 m²/g, determined by means of a BET measurement according to DIN ISO 9277:2014-01, static-volumetric measuring method, gas used: nitrogen.

5. The silver sinter paste according to any of the preceding claims, in which the silver flakes have a tapped density in the range of 1 to 5 g/cm³, determined according to DIN EN ISO 787-11:1995-10.

6. The silver sinter paste according to any of the preceding claims, in which the silver particles have an aspect ratio of 1:1 to 5:1, determined by scanning electron microscopy and evaluation of the electron microscopic images by determining the dimensions of a statistically significant number of individual particles.

7. The silver sinter paste according to any of the preceding claims, in which the silver particles have a specific surface area in the range of 1 to 8 m²/g, determined by means of a BET measurement according to DIN ISO 9277:2014-01, static-volumetric measuring method, gas used: nitrogen.

8. The silver sinter paste according to any of the preceding claims, in which the silver particles have a tapped density in the range of 3 to 6 g/cm³, determined according to DIN EN ISO 787-11:1995-10.

9. The silver sinter paste according to any of the preceding claims, wherein the at least one cellulose derivative is selected from the group consisting of methyl cellulose, ethyl cellulose, ethyl methyl cellulose, carboxy cellulose, hydroxypropyl cellulose, hydroxyethyl cellulose and hydroxymethyl cellulose.

10. The silver sinter paste according to any of the preceding claims, not comprising any glass particles.

11. The silver sinter paste according to any of the preceding claims, not comprising any thermally decomposable metal precursors.

12. A method for joining components, in which a sandwich arrangement is provided (1), which comprises at least two components and a silver sinter paste according to any of the preceding claims located between the components, the silver sinter paste is optionally dried (2) and the sandwich arrangement is sintered (3).

13. The method according to claim 12, wherein sintering is carried out under pressure or without pressure.

14. The method according to claim 12 or 13, wherein the components are components used in electronics.

## Revendications

1. Pâte de frittage d'argent constituée de :
(A) 5 à 40 % en poids de paillettes d'argent comportant une taille de particule D90 dans la plage allant de 5 à 20 µm,
(B) 50 à 85 % en poids de particules d'argent comportant une taille de particule D90 dans la plage allant de 300 à 1000 nm,
(C) 10 à 25 % en poids d'au moins un solvant organique,
(D) 0 à 2 % en poids d'au moins un dérivé de cellulose, et
(E) 0 à 10 % en poids d'au moins un additif différent des constituants (A) à (D) susmentionnés,
le concept « taille de particule D90 » utilisé en relation avec les paillettes d'argent (A) signifiant le diamètre de particule primaire déterminé au moyen d'une analyse statique automatisée d'images microscopiques, lequel diamètre de particule primaire n'est pas atteint par une fraction volumique de 90 % des particules, et
le concept « taille de particule D90 » utilisé en relation avec les particules d'argent (B) signifiant le diamètre de particule primaire déterminé au moyen d'une diffraction laser, lequel diamètre de particule primaire n'est pas atteint par une fraction volumique de 90 % des particules.

2. Pâte de frittage d'argent selon la revendication 1, comportant une taille de particule D10 dans la plage allant de 0,5 à 2 µm et D50 dans la plage allant de 2,4 à 4 µm pour les paillettes d'argent et comportant une taille de particule D10 dans la plage allant de 90 à 150 nm et D50 dans la plage allant de 150 à 250 nm pour les particules d'argent, le concept « taille de particule D10 » utilisé en relation avec les paillettes d'argent (A) signifiant le diamètre de particule primaire déterminé au moyen d'une analyse statique automatisée d'images microscopiques, lequel diamètre de particule primaire n'est pas atteint par une fraction volumique de 10 % des particules,
le concept « taille de particule D50 » utilisé en relation avec les paillettes d'argent (A) signifiant le diamètre de particule primaire moyen en volume déterminé au moyen d'une analyse statique automatisée d'images microscopiques,
le concept « taille de particule D10 » utilisé en relation avec les particules d'argent (B) signifiant le diamètre de particule primaire déterminé au moyen d'une diffraction laser, lequel diamètre de particule primaire n'est pas atteint par une fraction volumique de 10 % des particules, et
le concept « taille de particule D50 » utilisé en relation avec les particules d'argent (B) signifiant le diamètre de particule primaire moyen en volume déterminé au moyen d'une diffraction laser.

3. Pâte de frittage d'argent selon la revendication 1 ou 2, comportant un rapport d'aspect des paillettes d'argent > 5:1, lequel est déterminé par microscopie électronique à balayage et par évaluation des images de microscopie électronique en déterminant les dimensions d'un nombre statistiquement significatif de particules individuelles.

4. Pâte de frittage d'argent selon l'une des revendications précédentes, comportant une surface spécifique des paillettes d'argent dans la plage allant de 1 à 5 m²/g, laquelle surface est déterminée au moyen d'une mesure BET selon la norme DIN ISO 9277:2014-01, procédé de mesure statique-volumétrique, gaz utilisé : azote.

5. Pâte de frittage d'argent selon l'une des revendications précédentes, comportant une densité tassée des paillettes d'argent dans la plage allant de 1 à 5 g/cm³, laquelle densité tassée est déterminée selon la norme DIN EN ISO 787-11:1995-10.

6. Pâte de frittage d'argent selon l'une des revendications précédentes, comportant un rapport d'aspect des particules d'argent dans la plage allant de 1:1 à 5:1, lequel est déterminé par microscopie électronique à balayage et par évaluation des images de microscopie électronique en déterminant les dimensions d'un nombre statistiquement significatif de particules individuelles.

7. Pâte de frittage d'argent selon l'une des revendications précédentes, comportant une surface spécifique des particules d'argent dans la plage allant de 1 à 8 m²/g, laquelle surface est déterminée au moyen d'une mesure BET selon la norme DIN ISO 9277:2014-01, procédé de mesure statique-volumétrique, gaz utilisé : azote.

8. Pâte de frittage d'argent selon l'une des revendications précédentes, comportant une densité tassée des particules d'argent dans la plage allant de 3 à 6 g/cm³, laquelle densité tassée est déterminée selon la norme DIN EN ISO 787-11:1995-10.

9. Pâte de frittage d'argent selon l'une des revendications précédentes, l'au moins un dérivé de cellulose étant choisi dans le groupe constitué de méthylcellulose, éthylcellulose, éthylméthylcellulose, carboxycellulose, hydroxypropylcellulose, hydroxyéthylcellulose et hydroxyméthylcellulose.

10. Pâte de frittage d'argent selon l'une des revendications précédentes, ne comprenant pas de particules de verre.

11. Pâte de frittage d'argent selon l'une des revendications précédentes, ne comprenant pas de précurseurs métalliques décomposables thermiquement.

12. Procédé pour la liaison de composants, dans lequel on (1) fournit un agencement en sandwich présentant au moins deux composants et une pâte de frittage d'argent selon l'une des revendications précédentes se trouvant entre les composants, (2) sèche éventuellement la pâte de frittage d'argent, et (3) fritte l'agencement en sandwich.

13. Procédé selon la revendication 12, le frittage ayant lieu sous application de pression ou sans pression.

14. Procédé selon la revendication 12 ou 13, les composants étant des composants utilisés en électronique.
